# EUROPÄISCHE PATENTSCHRIFT

(11) **EP 3 161 918 B1**
(45) Veröffentlichungstag und Bekanntmachung des Hinweises auf die Patenterteilung: **07.08.2019**
(21) Anmeldenummer: 15729160.0
(22) Anmeldetag: 15.06.2015
(51) Int. Cl.: H02H 1/00, G01R 31/12, G01R 31/00

(54) **VERFAHREN UND VORRICHTUNG ZUR LICHTBOGENERKENNUNG**
METHOD AND DEVICE FOR DETECTING ARCS
PROCÉDÉ ET DISPOSITIF DE DÉTECTION D'ARC ÉLECTRIQUE

(30) Priorität: 25.06.2014 DE 102014108870
(43) Veröffentlichungstag der Anmeldung: 03.05.2017
(73) Patentinhaber: Herges, Peter, 70469 Stuttgart (DE)
(72) Erfinder: Herges, Peter, 70469 Stuttgart (DE)
(74) Vertreter: Fleck, Hermann-Josef
(86) Internationale Anmeldenummer: PCT/EP2015/063296
(87) Internationale Veröffentlichungsnummer: WO 2015/197399

(56) Entgegenhaltungen:
- EP-A1- 1 553 422
- EP-A1- 2 466 709
- WO-A1-99/30400
- US-A1- 2006 092 585

## Beschreibung

Die Erfindung betrifft ein Verfahren zur Lichtbogenerkennung in einem Gleichstromkreis mit einem Detektionsleiter, welcher zumindest entlang einem eine elektrische Spannung führenden und zu überwachenden Leiter des Gleichstromkreises geführt ist, sowie eine Vorrichtung zur Durchführung des Verfahrens.

Ein Verfahren beziehungsweise eine Vorrichtung dieser Art ist in der DE 101 32 750 A1 angegeben. Diese Druckschrift beschreibt eine Sicherungsanordnung für eine elektrische Leitung in einem Fahrzeug. Dabei ist ein Doppelleiter entlang einer zu überwachenden Leitung oder eines zu überwachenden Kabelbaums geführt. Die beiden Leitungen des Doppelleiters sind durch eine Isolation voneinander getrennt und liegen auf einem unterschiedlichen Potential. Durch einen Kurzschluss in der zu überwachenden Leitung/dem Kabelbaum schmilzt die Isolation und die Leiter des Doppelleiters treten in Kontakt. Dadurch fließt ein Strom zwischen den Leitern, der nachgewiesen und für eine Lichtbogenerkennung ausgewertet wird. Bei dieser bekannten Ausführung wird nach einem Ausführungsbeispiel ein Leiter auf ein vorgegebenes Potential und der zweite Leiter auf Masse gelegt. Bei einem anderen Ausführungsbeispiel wird die Potentialdifferenz durch einen Spannungsteiler erzeugt, wobei eine Spannung über einen ersten Widerstand einem ersten Leiter des Doppelleiters an dessen vorderen Ende zugeführt wird. Die beiden Doppelleiter sind endseitig mit einem zweiten Widerstand verbunden. Der zweite Leiter ist an seinem vorderen Ende über einen dritten Widerstand mit Masse verbunden. Diese bekannte Sicherungsanordnung ist so ausgelegt, dass die beiden auf unterschiedlichem Potential liegenden Leiter des Detektionsleiters derart entlang der zu überwachenden elektrischen Leitung geführt sein müssen, dass sie bei einem Kurzschluss in elektrischen Kontakt treten.

Ein weiteres Verfahren und eine Vorrichtung zur Lichtbogenerkennung in Bordnetzen von Kraftfahrzeugen zeigt die EP 1 553 422 A1. Bei dieser bekannten Ausführung ist ein Versorgungsleitungssystem mit einem Detektorleitungssystem versehen, welches an einem ersten Ende mit einer Detektorschaltung und an mindestens einem weiteren Ende mit einem Abschlusselement, wie einem Widerstand oder Schalter verbunden ist. Die Detektorschaltung erfasst einen Defekt, wie z. B. Ausbildung eines Lichtbogens, durch Abweichung eines Prüfsignals von einem Sollwert.

Weitere Vorrichtungen mit Erfassungsschaltung für einen Lichtbogen sind in der EP 2 466 709 A1 und der US 2006/092585 A1 gezeigt.

Die DE 10 2012 019 996 A1 beschreibt ein Verfahren zur Überwachung eines Leitungsnetzes auf einen Lichtbogen hin. Dazu ist eine Sensorleitung über einen ersten Widerstand und eine Masseleitung mit Masse verbunden. Ausgewertet wird ein Spannungsanstieg in der Sensorleitung. Dieser kann erfolgen, wenn die Masseleitung durch einen Lichtbogen unterbrochen wird oder wenn in Folge eines Lichtbogens ein elektrischer Kontakt zu einer spannungsführenden Leitung des zu überwachenden Leitungsnetzes auftritt. Bei dieser bekannten Ausführung handelt es sich um ein aktives Sicherheitssystem, welches im Grundzustand stromlos ist und im Fehlerfall zu einem Stromfluss führt.

Das Bordnetz von Personenkraftwagen wird heute üblicherweise mit 12V betrieben. Demgegenüber bietet ein Bordnetz von 42V bzw. 48V deutliche Vorteile, beispielsweise in Form einer CO₂-Reduktion auf Grund verbesserter Rekuperationsmöglichkeiten oder der möglichen Reduzierung des Fahrzeuggewichtes. Dabei liegen die vorgesehenen Spannungen unter dem Berührungsschutzbereich ab 60V, der besondere Sicherheitsvorkehrungen erfordert.

Mit steigender Spannung steigt das Risiko zur Ausbildung eines Lichtbogens. Ein Lichtbogen kann zwischen zwei Bauteilen mit unterschiedlichem Potential, beispielsweise zwischen einem Pluskabel und einem Minuskabel, oder auch entlang des Strompfades im Bereich erhöhter Übergangswiderstände auftreten. Erhöhte Übergangswiderstände werden beispielsweise durch korrodierte Kontaktstellen oder durch beschädigte elektrische Leiter verursacht. Während eine Spannung von 12V noch unter der erforderlichen Zündspannung eines Lichtbogens liegt, besteht bei den für Kraftfahrzeuge vorgesehenen 42V bzw. 48V eine erhöhte Gefahr zur Ausbildung eines solchen Lichtbogens, der sich bereits ab ca. 20V stabilisiert und damit ein beträchtliches Brandrisiko für das Fahrzeug mit entsprechender Personengefährdung darstellt. Dabei sprechen für die Überwachung elektrischer Verbraucher und deren Zuleitungen vorgesehene Sicherungen nicht oder nur verzögert an, da die auftretenden Ströme bei einem Lichtbogen zwischen zwei Bauteilen mit unterschiedlichem Potential im Vergleich zu einem direkten Kurzschluss geringer sind und bei einem Lichtbogen entlang des Strompfades gegenüber dem regulären Betrieb eines angeschlossenen Verbrauchers sogar reduziert sein können.

Aus der Schrift DE 101 32 752 B4 sind ein Verfahren und eine Vorrichtung zum Schutz eines Leiters bei Auftreten eines Lichtbogens bekannt. Dabei ist eine isolierte Detektionsleitung entlang einer zu überwachenden Versorgungsleitung geführt. Tritt ein Lichtbogen auf, schmilzt die Isolation der Detektionsleitung und es kommt zu einem direkten Kontakt zwischen der Detektionsleitung und der Versorgungsleitung. Dies bewirkt einen Stromfluss in der Detektionsleitung, welcher zur Erkennung eines Lichtbogens verwendet wird. Nachteilig hierbei ist, dass ein direkter Kontakt zwischen der Detektionsleitung und der Versorgungsleitung erforderlich ist, um den für einen Lichtbogen charakteristischen Stromfluss zu bewirken. Dies ist in dem unkontrollierten und heißen Bereich eines Lichtbogens, bei dem Isolationsmaterial unter entsprechender Gasentwicklung schlagartig verbrennen kann, nicht sicher gegeben. Vielmehr können Versorgungs- und Detektionsleitung im Bereich des Lichtbogens räumlich getrennt werden, wodurch der Stromfluss nicht zustande kommt oder unter einen sicher auswertbaren Bereich fällt. Die Schrift sieht hier die Verwendung eines speziellen Isolationsmaterials mit einem Schmelzpunkt zwischen 130° und 180° vor, welches im Falle eines Lichtbogens kontrolliert abfließt. Im Bereich eines Lichtbogens treten jedoch Temperaturen von deutlich über 1000°C auf, was zu einer Zersetzung des Isolationsmaterials führt. Ein weiterer Nachteil ergibt sich dadurch, dass es sich bei dem System um ein aktives Sicherheitssystem handelt, welches im regulären Betrieb stromlos ist und im Fehlerfall einen nachzuweisenden Strom führt. Ein Defekt in dem Sicherheitssystem, beispielsweise durch korrodierte Kontakte der Detektionsleitung, kann im Fehlerfall dazu führen, dass trotz Lichtbogen kein Stromfluss in der Detektionsleitung möglich ist und der Lichtbogen daher unerkannt bleibt. Um dies zu vermeiden, sind aufwändige und entsprechend kostspielige Kontakte erforderlich. Um den Sicherheitsstandards für eine aktive Sicherheitsschaltung im Automotivbereich zu genügen ist es erforderlich, diese kontinuierlich zu überprüfen, beispielsweise, indem der Widerstand der Detektionsleitung überwacht wird. Dies ist ebenfalls sehr aufwändig und mit entsprechenden Kosten verbunden.

Die Schrift DE 101 50 377 A1 beschreibt ein Verfahren und eine Vorrichtung zur Kurzschlusserkennung von Signalleitungen eines Sensors. Dazu wird an die zu überwachende Signalleitung zusätzlich zu dem Sensorsignal über einen Vorwiderstand ein statisches Referenzpotential angelegt. Ein Kurzschluss liegt vor, wenn das nach dem Vorwiderstand an der Signalleitung anliegende, statische Potential außerhalb eines vorbestimmten Bereichs liegt. Das Verfahren lässt sich nur für Signalleitungen anwenden, die im Wesentlichen leistungsfrei betrieben werden und bei denen der Signalverlauf entsprechend hochohmig erfasst und ausgewertet wird. Versorgungsleitungen eines Verbrauchers in einem Gleichstromkreis kann kein statisches Referenzpotential überlagert werden, da dies unmittelbar zu einer veränderten Leistungsaufnahme des Verbrauchers und, bei begrenzter Leistung der Referenzspannungsquelle, zu einer Veränderung des zu überwachenden statischen Potentials führt.

Aus der Schrift DE 199 35 439 A1 ist eine Sensorleitung mit mindestens zwei durch einen Isolator getrennten Leiterelementen bekannt. Der Isolator besteht aus einem Werkstoff mit einer durch äußere Einflüsse, insbesondere durch eine Temperaturerhöhung, veränderbaren elektrischen Leitfähigkeit. Steigt die Temperatur in einem Bereich der Sensorleitung, beispielsweise durch einen Brand, werden die Leiterelemente durch den dann leitfähigen Isolator kurzgeschlossen. Dieser Kurzschluss wird nachgewiesen und darüber ein potentieller Brandherd erkannt. Nachteilig bei diesem Verfahren ist, dass ein spezieller, bei höheren Temperaturen (T ≥ 80°C) leitfähiger Kunststoff als Isolator benötigt wird. Ein weiterer Nachteil besteht darin, dass sich auch dieser Kunststoff bei den in einem Lichtbogen auftretenden hohen Temperaturen unmittelbar zersetzt, so dass sich keine leitfähige Phase ausbildet. Eine Lichtbogenerkennung ist demnach mit der beschriebenen Sensorleitung nicht möglich.

Wie bereits zu der DE 101 32 752 B4 beschrieben, handelt es sich auch bei der aus der DE 199 35 439 A1 bekannten Anordnung nachteilig um ein aktives Sicherheitssystem, welches im regulären Betrieb stromlos ist und im Fehlerfall einen nachzuweisenden Strom führt. Ein Defekt in dem Sicherheitssystem, beispielsweise durch korrodierte Kontakte der Detektionsleitung, kann daher auch hier im Fehlerfall dazu führen, dass trotz einer leitfähigen Verbindung zwischen den Leiterelementen kein Stromfluss in der Detektionsleitung möglich ist und der Fehler daher unerkannt bleibt. Für eine Anwendung in einem automobilen Bereich ist die Anordnung daher nicht zertifizierungsfähig.

Es ist Aufgabe der Erfindung, ein Verfahren bereitzustellen, welches eine sichere und kostengünstige Erkennung eines Lichtbogens in einem Gleichstromkreis ermöglicht.

Es ist weiterhin eine Aufgabe der Erfindung, eine entsprechende Vorrichtung bereitzustellen.

Die das Verfahren betreffende Aufgabe der Erfindung wird dadurch gelöst, dass ein auf ein Potential des Gleichstromkreises bezogenes Spannungssignal über einen Vorwiderstand an einer Einkoppelstelle in den Detektionsleiter eingekoppelt wird, dass das Spannungssignal an einer Auskoppelstelle des Detektionsleiters wieder ausgekoppelt wird, dass das Spannungssignal vor dem Vorwiderstand mit dem Spannungssignal an der Auskoppelstelle verglichen wird und dass auf einen Lichtbogen geschlossen wird, wenn das Spannungssignal an der Auskoppelstelle um mehr als einen vorgegebenen Betrag von dem Spannungssignal vor dem Vorwiderstand abweicht. Im regulären Betrieb wird der Detektionsleiter nicht oder durch die hochohmige Spannungsmessung nur gering elektrisch belastet. Damit sind die Spannungssignale vor und nach dem Vorwiderstand zumindest annähernd gleich. Tritt ein Lichtbogen auf, führt dies durch die damit verbundenen, sehr hohen Temperaturen unmittelbar zu einer ionisierten und damit leitfähigen Atmosphäre im Bereich des Lichtbogens. Zu dieser ionisierten Atmosphäre tragen auch die Verbrennungsprodukte von Isolationsmaterialien, beispielsweise eines zu überwachenden Kabels, bei. Diese ionisierte Atmosphäre ermöglicht einen von dem Detektionsleiter ausgehenden Stromfluss. Bei einem Stromfluss steigt der Spannungsabfall über dem Vorwiderstand, so dass sich die Spannung an der Auskoppelstelle des Detektionsleiters verringert. Dies wird durch den Vergleich der Spannungssignale vor dem Vorwiderstand und an der Auskoppelstelle erkannt und damit der Lichtbogen nachgewiesen.

Durch geeignete Wahl des Vorwiderstandes kann auch bei einer vergleichsweise geringen Strombelastung des Detektionsleiters über die ionisierte Atmosphäre ein deutliche Änderung der Spannung an der Auskoppelstelle bewirkt werden, so dass ein Lichtbogen schon sehr früh in seiner Entstehung erkannt werden kann.

Ein weiterer wesentlicher Vorteil besteht darin, dass die Lichtbogenerkennung als passives Sicherheitssystem ausgeführt ist. Ein spannungsloser Zustand des Detektionsleiters wird als Lichtbogen mit den dann vorgesehenen Maßnahmen erkannt. Tritt ein solcher spannungsloser Zustand durch einen anderen Fehler, beispielsweise durch korrodierte Kontakte oder einen unterbrochenen Detektionsleiterleiter, auf, werden auch diese Maßnahmen ergriffen und die volle Sicherheit ist gegeben. Es liegt somit ein ständig geschlossener Detektionsstromkreis vor, der kontinuierlich auf Unterbrechung geprüft wird und bei einer Unterbrechung die vorgesehenen Sicherheitsmaßnahmen einleitet. Das Verfahren ermöglicht es dadurch, die Vorgaben bezüglich der Ausfallsicherheit sicherheitsrelevanter Bauteile, wie sie beispielsweise für Kraftfahrzeuge gelten, einzuhalten. Fehlerquoten von 10⁻¹⁰ Fehlern pro Jahr sind erreichbar, da der sichere Zustand die Abschaltung darstellt.

Ein weiterer Vorteil des Verfahrens ergibt sich dadurch, dass kein direkter Kontakt zwischen dem Detektorleiter und einem weiteren Leiter des Gleichstromkreises erforderlich ist, welcher sich unter ungünstigen Bedingungen innerhalb des Lichtbogens nicht ergibt. Zur Auswertung genügt es, wenn der Detektionsleiter durch den ionisierten Bereich des Lichtbogens geführt ist. Gleichzeitig erfolgt eine Spannungsänderung des Detektionsleiters aber auch dann, wenn ein solcher direkter Kontakt vorliegt, so dass in beiden Fällen eine sichere Erkennung eines Lichtbogens ermöglicht ist.

Damit im Falle eines Lichtbogens der Detektionsleiter sicher elektrisch belastet wird, ist es vorgesehen, dass das Spannungssignal auf ein Potential des Gleichstromkreises bezogen ist. Dabei kann es sich um das Minuspotential, aber auch um das Pluspotential und somit die Betriebsspannung des Gleichstromkreises oder ein zwischen dem Minuspotential und dem Pluspotential liegendes Potential handeln.

Entsprechend bevorzugter Ausgestaltungsvarianten der Erfindung kann es vorgesehen sein, dass als Spannungssignal ein Gleichspannungssignal oder ein Wechselspannungssignal oder ein von einer Wechselspannung überlagertes Gleichspannungssignal verwendet wird. Ein Gleichspannungssignal lässt sich in dem zu überwachenden Gleichspannungssystem einfach und kostengünstig bereitstellen. Demgegenüber bietet eine Wechselspannung den Vorteil einer zuverlässigen Erkennung. Unter den undefinierten Bedingungen eines Lichtbogens können sich beliebige Gleichspannungen von Masse bis zur Spannung des Spannungssignals oder der Versorgungsspannung des Gleichstromkreises auf dem Detektionsleiter einstellen, wodurch die Fehlererkennung auf Basis eines Gleichspannungssignals erschwert wird. Eine Wechselspannung lässt sich hingegen eindeutig von den möglichen überlagerten Gleichspannungen unterscheiden und sicher auswerten. Dabei können Sinusspannungen, aber auch beliebige andere Wechselspannungen, wie Sägezahn-, Dreieck- und Rechteckspannungen, vorgesehen sein. Die Auswertung kann phasen- und/oder frequenzselektiv durchgeführt werden, um Störspannungen sicher auszuschließen.

Entsprechend einer besonders bevorzugten Ausgestaltungsvariante der Erfindung kann es vorgesehen sein, dass die Spannungsversorgung des Gleichstromkreises unterbrochen wird, wenn ein Lichtbogen erkannt wird. Dies führt kurzfristig zum Erlöschen des Lichtbogens, wodurch größerer Schäden vermieden werden können.

Die die Vorrichtung betreffende Aufgabe der Erfindung wird dadurch gelöst, dass der Detektionsleiter an einer Einkoppelstelle über einen Vorwiderstand mit einer ein Spannungssignal ausgebenden Signalquelle verbunden ist, dass das Spannungssignal der Signalquelle auf ein Potential des zu überwachenden Gleichspannungsstromkreises bezogen ist, dass das von der Signalquelle ausgegebene Spannungssignal und ein an einer Auskoppelstelle des Detektionsleiters ausgegebenes Spannungssignal einem Vergleicher zugeführt ist und dass der Vorrichtung eine Verarbeitungseinrichtung zugeordnet ist, welche auf einen Lichtbogen erkennt, wenn das an der Auskoppelstelle vorliegende Spannungssignal über einen vorgegebenen Betrag von dem von der Signalquelle ausgegebenen Spannungssignal abweicht. Die Vorrichtung ermöglicht so die Durchführung des beschriebenen Verfahrens, bei dem ein durch die ionisierte Atmosphäre im Bereich eines Lichtbogens ermöglichter Stromfluss, ausgehend von dem Detektionsleiter, zu einer Änderung des Spannungssignals an der Auskoppelstelle bei gleichbleibendem Spannungssignal vor dem Vorwiderstand führt. Der Vergleich der Spannungssignale kann durch eine Differenzmessung in dem Vergleicher erfolgen. Alternativ können die Spannungssignale vor dem Vorwiderstand und an der Auskoppelstelle auch separat erfasst und dann verglichen werden. Als Verarbeitungseinrichtung kann eine elektronische Schaltung oder ein Mikroprozessor vorgesehen sein, welche eine von dem Vergleicher bestimmte Spannungsdifferenz erfasst und daraufhin entscheidet, ob ein Lichtbogen vorliegt oder nicht. Als Entscheidungskriterium für das Vorliegen eines Lichtbogens kann auch gewählt sein, dass das Spannungssignal an der Auskoppelstelle nicht mehr vorliegt, dass der vorgegebene Betrag demnach dem Betrag des Spannungssignals entspricht.

Um einen Stromfluss durch die ionisierte Atmosphäre eines Lichtbogens zwischen dem Detektionsleiter und einem Leiter des Gleichstromkreises zu ermöglichen, muss das Spannungssignal der Signalquelle auf ein Potential des zu überwachenden Gleichspannungsstromkreises bezogen sein.

Entsprechend einer bevorzugten Variante der Erfindung kann es vorgesehen sein, dass der Detektionsleiter als geschlossene Leiterschleife ausgeführt ist, wobei die Einkoppelstelle und die Auskoppelstelle an den Enden der Leiterschleife angeordnet sind. Zur Überwachung beispielsweise eines den Leiter des Gleichstromkreises führenden Kabels kann es somit vorgesehen sein, dass der Detektionsleiter, ausgehend von der Einkoppelstelle, mit einer Zuführung entlang dem Kabel verläuft und dann über eine Rückführung wieder entlang dem Kabel an dessen Anfang zur Auskoppelstelle zurückgeführt wird. Die Anordnung ermöglicht es, die Einkoppelstelle und die Auskoppelstelle an einem Ende des Kabels anzuordnen, was einen einfachen Anschluss an eine elektronische Schaltung mit der Signalquelle, dem Vorwiderstand und dem Vergleicher ermöglicht. Dabei sind sowohl die Zu- wie die Rückführung entlang des zu überwachenden Leiters in der an dem Kabel angeordnet, womit zumindest ein Teil des Detektionsleiters sicher in den Bereich eines auftretenden Lichtbogens fällt. Das Spannungssignal der Signalquelle wird über den Vorwiderstand an der Einkoppelstelle des Detektionsleiters eingekoppelt. Am Ende des Detektionsleiters wird das Spannungssignal an der Auskoppelstelle abgegriffen und dem Vergleicher zugeführt. Tritt ein Lichtbogen auf, wird das Spannungssignal durch die in dem Lichtbogen auftretenden Ionen derart gestört, dass dies in dem am Ende des Detektionsleiters vorliegenden Spannungssignals deutlich erkannt werden kann.

Um einen Leiter des Gleichstromkreises über seine gesamte Länge überwachen zu können kann es vorgesehen sein, dass der Detektionsleiter an Kontaktstellen des zu überwachenden Gleichstromkreises ebenfalls als Kontakt ausgeführt ist und/oder dass der Kontakt des Detektionsleiters als Interlockschaltung mit einer Verzögerungseinrichtung, insbesondere nach- oder vor eilende Kontakte ausgeführt ist. Der Detektionsleiter kann so, beispielsweise als zusätzlicher Steckkontakt, in einen Stecker des Gleichstromkreises integriert sein. Damit können auch Kontaktstellen des Gleichstromkreises, wie beispielsweise der genannte Stecker, auf einen darin ausgebildeten Lichtbogen überwacht werden. Ist der Kontakt des Detektionsleiters als Interlockschaltung mit einer Verzögerungseinrichtung ausgeführt, kann der Sicherheitsstandard für die Kontaktstelle erhöht werden. Bei einer solchen Interlockschaltung muss zunächst der Kontakt des Detektionsleiters, beispielsweise durch aufschrauben, gelöst werden, bevor der Hauptstecker des Gleichstromkreises geöffnet werden kann. Vor dem Lösen des Steckers ist es vorgesehen, dass der Gleichstromkreis unterbrochen wird. Wird dies vergessen, führt das Öffnen des Detektionsleiters zur Abschaltung des Gleichstromkreises. Dies ist beispielsweise für elektrische Verbindungen zu Anhängern an Nutzfahrzeugen sinnvoll, da so die Spannungsversorgung sicher abgeschaltet wird, bevor der Hauptstecker getrennt wird.

Um Lichtbögen im gesamten Gleichstromkreis nachweisen zu können kann es vorgesehen sein, dass der Detektionsleiter durch Verbraucher hindurch oder entlang von Verbrauchern des Gleichstromkreises geführt ist und/oder dass der Detektionsleiter durch Kabel oder entlang von Kabeln des Gleichstromkreises geführt ist. Der Detektionsleiter ist dabei vorteilhaft innerhalb beispielsweise eines Gehäuses des Verbrauchers verlegt, da die Atmosphäre im Innenraum des Gehäuses im Falle eines Lichtbogens kurzfristig ionisiert wird, so dass eine sehr schnelle Erkennung des Lichtbogens ermöglicht wird. Um hier einen großflächigen Überwachungsbereich zu erhalten, kann der Detektionsleiter im Bereich der Verbraucher entsprechend großflächig, beispielsweise in Form eines Sensorbleches, ausgeführt sein. Mögliche zu überwachende Verbraucher sind Klimakompressoren, Lichtmaschinen, Starter, Antriebs-Elektroniken oder Lenkhilfen. Vorteilhaft bei der Überwachung von Verbrauchern auf Lichtbögen ist, dass es sich dabei meist um hochwertige und entsprechend teure Bauteile handelt, deren vollständige Zerstörung bei rechtzeitiger Erkennung eines Lichtbogens und entsprechender Abschaltung der Spannungsversorgung vermieden werden kann. Durch die Führung des Detektionsleiters durch oder entlang von Kabeln des Gleichstromkreises können diese auf Lichtbögen überwacht werden.

Durch den Vorwiderstand und den Widerstand, welcher sich innerhalb des Lichtbogens zwischen dem Detektionsleiter und einem Bezugspotential ausbildet, ist ein Spannungsteiler aufgebaut. Durch geeignete Wahl des Vorwiderstandes kann der Spannungsteiler so ausgelegt werden, dass bei den erwarteten Widerständen innerhalb des Lichtbogens eine maximale Änderung des Spannungssignals an der Auskoppelstelle vorliegt. Dies kann dadurch erreicht werden, dass der Vorwiderstand in einem Bereich zwischen 10 Ohm und 10.000 Ohm (10 k Ohm), beispielsweise zwischen 100 Ohm und 10.000 Ohm, bevorzugt in einem Bereich zwischen 300 Ohm und 3000 Ohm, liegt. Bei einem Vorwiderstand von beispielsweise 1000 Ohm können Lichtbögen schon in ihrer Entstehung, während der noch vergleichsweise wenig ionisiertes Gas und damit ein entsprechend hoher Widerstand vorliegt, an Hand des einbrechenden Spannungssignals an der Auskoppelstelle erkannt werden. Bei Fahrzeugen, wie Busse, sind relativ große Kabellängen zu überwachen. Um eine hohe Leistung auf dem Detektionsleiter zu erhalten, kann es von Vorteil sein, z. B. mit einem Vorwiderstand im Bereich von 10 Ohm bis 50 Ohm zu arbeiten.

Es kann vorgesehen sein, dass die Signalquelle als Wechselspannungsquelle oder als Gleichspannungsquelle oder als Wechselspannungsquelle mit überlagertem Gleichspannungsoffset ausgeführt ist. Die Verwendung einer Wechselspannungsquelle bietet den Vorteil einer einfachen Unterscheidung gegenüber Gleichspannungen, welche bei Auftreten eines Lichtbogens aus dem Gleichstromkreis auf den Detektionsleiter übertragen werden können. Gleichspannungsquellen sind hingegen in der zu überwachenden Gleichspannungsumgebung einfacher und kostengünstiger bereitzustellen.

Um größere Schäden beim Auftreten eines Lichtbogens zu vermeiden kann es vorgesehen sein, dass die Verarbeitungseinrichtung dazu ausgelegt ist, bei einem erkannten Lichtbogen eine Trenneinrichtung anzusteuern, welche die Spannungsversorgung des Gleichstromkreises unterbricht. Zur Unterbrechung der Spannungsversorgung können Hochleistungs-Trenneinrichtungen verwendet werden, welche beispielsweise ein Batterie oder einen Generator eines Kraftfahrzeugs von dem Gleichstromkreis abtrennen. Sie sind dazu ausgelegt, dass sie auch unter Kurzschlussbedingungen bei hohen Strömen sicher schalten, ohne dass in ihnen selbst ein Lichtbogen auftritt. Als Hochleistungs-Trenneinrichtungen können Hochleistungs-Trennrelais, elektronische Trenneinrichtungen oder pyrotechnische Sicherungen vorgesehen sein. Die Hochleistungs-Trenneinrichtung kann unmittelbar an oder in der Batterie oder an oder in dem Generator angeordnet sein.

Mögliche Erfindungsvarianten sehen vor, dass der Detektionsleiter zumindest bereichsweise isoliert ausgeführt ist und/oder dass der Detektionsleiter zumindest bereichsweise ohne Isolation ausgeführt ist. Ein isolierter Detektionsleiter kann in direktem Kontakt ohne die Gefahr eines versehentlichen Kurzschlusses mit dem zu überwachenden Leiter des Gleichstromkreises verlegt werden. Tritt ein Lichtbogen auf, wird die Isolation zerstört und es bildet sich die ionisierte und dadurch leitfähige Atmosphäre aus. Bei einem blanken Detektionsleiter muss nicht zunächst eine Isolation verbrannt werden, so dass sich eine sehr schnelle Reaktionsgeschwindigkeit bei Auftreten eines Lichtbogens ergibt. Vorteilhaft kann ein Teil des Detektionsleiters, beispielsweise die Zuführung eines als Leiterschleife ausgeführten Detektionsleiters, isoliert und ein andere Teil des Detektionsleiters, beispielsweise dessen Rückführung, blank vorliegen, so dass beide Vorteile kombiniert werden können. Bei einem blanken Detektionsleiter ist darauf zu achten, dass dieser im normalen, lichtbogenfreien Betrieb nicht mit anderen spannungsführenden Bauteilen oder mit Masse in Kontakt kommt. In einer Ausführungsform kann der Detektionsleiter dazu gemeinsam mit einem zu überwachenden Kabel in einem Schlauch geführt sein.

Blanke Detektionsleiter sind weiterhin insbesondere innerhalb von Verbrauchern vorteilhaft. Tritt ein Lichtbogen im Gehäuse eines Verbrauchers auf, liegt kurzfristig im gesamten Innenraum ionisiertes und damit leitfähiges Gas vor. Bei Verwendung eines blanken Detektionsleiters muss nicht zunächst eine Isolation des Detektionsleiters verbrannt werden, so dass er sehr schnell auf die gebildete ionisierte Atmosphäre anspricht. Die Verwendung eines blanken Detektionsleiters zur Überwachung von Verbrauchern ist auch daher vorteilhaft, da nicht überall in dem Gehäuse genügend hohe Temperaturen vorliegen, um eine Isolation des Detektionsleiters zu verbrennen. Im Gegensatz zu einem isolierten Detektionsleiter spricht ein blanker Detektionsleiter auch dann an, wenn er innerhalb des Gehäuses des Verbrauchers nicht durch einen Bereich sehr hoher Temperaturen geführt ist, so lange die Atmosphäre in dem Gehäuse ausreichend ionisiert ist.

Entsprechend einer weiteren Erfindungsvariante kann es vorgesehen sein, dass Verbraucher des Gleichstromkreises einseitig auf einer Fahrzeugmasse liegen und dass die Versorgungsspannung über mit Detektionsleitern überwachte Plusleitungen zu den Verbrauchern geleitet ist. Ohne die erfindungsgemäße Lichtbogenüberwachung werden Verbraucher von Kraftfahrzeugen mit beispielsweise 42V- oder 48V-Bordnetzen über getrennte Plusleitungen und Minusleitungen elektrisch versorgt. Die Verwendung einer gemeinsamen Fahrzeugmasse als Minuspol, wie sie bei 12V-Bordnetzen üblich ist, wird auf Grund der großen Gefahr zur Ausbildung eines Lichtbogens zwischen spannungsführenden Leitungen und Masse nicht vorgesehen. Mit der erfindungsgemäßen Lichtbogenerkennung und Unterbrechung der Spannungsversorgung des Gleichstromkreises bei einem erkannten Lichtbogen kann wieder eine gemeinsame Fahrzeugmasse vorgesehen werden, ohne dass ein erhöhtes Risiko zur Ausbildung eines Lichtbogens und daraus zur Entstehung eines Fahrzeugbrandes besteht. Durch diese Maßnahme können die Kosten für den Kabelbaum eines Kraftfahrzeugs sowie das Gewicht des Kraftfahrzeugs deutlich reduziert werden.

Das Verfahren und die Vorrichtung lassen sich bevorzugt zur Überwachung eines Gleichstromkreises in einem Spannungsbereich zwischen 20V und 60V, beispielsweise zwischen 24V und 60V, oder zur Überwachung eines Gleichstromkreises in einem Kraftfahrzeug in einem Spannungsbereich zwischen 20V und 60V, beispielsweise 24V und 60V, vorzugsweise in einem Spannungsbereich zwischen 40V und 50V, anwenden.

Die Erfindung wird im Folgenden anhand eines in den Zeichnungen dargestellten Ausführungsbeispiels näher erläutert. Es zeigen:
- Fig. 1: in einer schematischen und perspektivischen Vorderansicht einen Schnitt durch ein zweipoliges Kabel mit einem Detektionsleiter,
- Fig. 2: in einer schematischen Darstellung eine Elektronikanordnung zur Lichtbogenerkennung an einem Kabel und einem Verbraucher eines Gleichstromkreises,
- Fig. 3: das in Fig. 1 gezeigte Kabel mit zu vergleichenden Signalverläufen im regulären Betrieb des Gleichstromkreises ohne Lichtbogen,
- Fig. 4: das in Fig. 1 gezeigte Kabel mit den zu vergleichenden Signalverläufen aus Fig. 3 bei Auftreten eines Lichtbogens,
- Fig. 5: die Elektronikanordnung zur Lichtbogenerkennung mit einer integrierten Sicherheitsschaltung zur Überwachung des Detektionsleiters und
- Fig. 6: ein Kabelpaar mit einem einpoligen Pluskabel und einem einpoligen Minuskabel,
- Fig. 7: ein einpoliges Kabel (Plusleitung) mit einem Detektionsleiter entlang der Plusleitung und
- Fig. 8: ein weiteres Ausführungsbeispiel für eine Schaltung mit einer Elektronikanordnung.

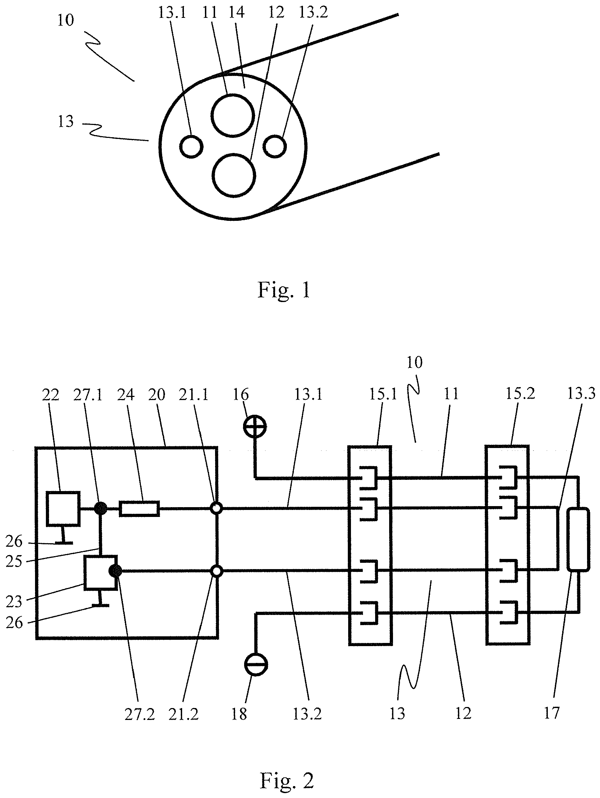

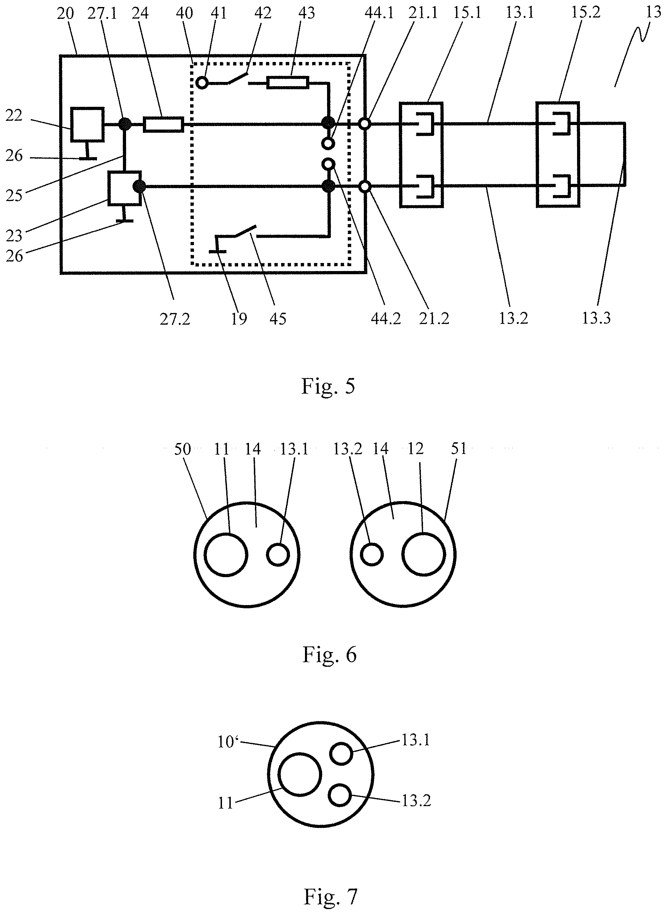

Fig. 1 zeigt in einer schematischen und perspektivischen Vorderansicht einen Schnitt durch ein zweipoliges Kabel 10 mit einem Detektionsleiter 13. Innerhalb einer isolierenden Ummantelung 14 sind eine Plusleitung 11 und eine Minusleitung 12 eines Gleichstromkreises geführt. Neben der Plusleitung 11 und der Minusleitung 12 sind eine Zuführung 13.1 und eine Rückführung 13.2 des Detektionsleiters 13 innerhalb der isolierenden Ummantelung 14 angeordnet. Die Zuführung 13.1 und die Rückführung 13.2 sind, wie in den Fig. 2 und 5 gezeigt, endseitig des Kabels 10 miteinander verbunden, so dass der Detektionsleiter 13 eine Leiterschleife bildet.

Das Kabel 10 ist Teil eines 48V Bordnetzes eines Kraftfahrzeugs und dient der Zuführung von elektrischer Energie an einen in Fig. 2 gezeigten elektrischen Verbraucher 17. In einer alternativen Ausführungsform kann der Detektionsleiter 13 außerhalb der Ummantelung 14 geführt sein oder er kann die Plusleitung 11 und die Minusleitung 14, beispielsweise spiralförmig, in Form eines Netzes oder als Schirm, umlaufen. Der Detektionsleiter 13 kann weiterhin in einem Schlauch um das Kabel 10 oder um die Plusleitung 11 oder die Minusleitung 12 mitgeführt sein. Um den Störabstand zur verbessern kann es weiterhin vorgesehen sein, dass der Detektionsleiter 13 als verdrillte Doppelleitung ausgeführt ist. Weiterhin ist es möglich, zwei Detektionsleiter 13 vorzusehen und so ein redundantes System zu schaffen.

Der Detektionsleiter 13 dient der Erkennung von Lichtbögen, welche sich beispielsweise entlang eines Strompfades entlang der Plusleitung 11 oder der Minusleitung 12 an Fehlstellen mit erhöhtem elektrischem Widerstand oder zwischen der Plusleitung 11 und der Minusleitung 12 ausbilden können. Solche Lichtbögen brennen ab Spannungen von 20V stabil und können schwere Schäden an dem Kraftfahrzeug verursachen. Mit dem Übergang von dem heute üblichen 12V-Bordnetz, dessen Spannung unter der erforderlichen Zündspannung für Lichtbögen liegt, zu 42V- bzw. 48V-Bordnetzen steigt das Risiko zu Ausbildung solcher Lichtbögen deutlich an. Tritt ein Lichtbogen, beispielsweise an einer korrodierten Kontaktstelle der Plusleitung 11 oder der Minusleitung 12 mit einem erhöhten elektrischen Widerstand, auf, so reduziert sich im Allgemeinen der Stromfluss durch die Plusleitung 11 bzw. Minusleitung 12, so dass zur Sicherung des Kabels 10 vorgesehene Schmelzsicherungen nicht auslösen. Bei zwischen der Plusleitung 11 und der Minusleitung 12 auftretenden Lichtbögen ist der Stromfluss zwar deutlich größer, liegt aber immer noch in einem Bereich, der zu einem verzögerten Ansprechen der Schmelzsicherung führen kann.

Tritt ein Lichtbogen auf, wird die Luft in dem Bereich ionisiert und damit leitfähig. Isolationsmaterial, welches sich in dem Bereich des Lichtbogens befindet, wird thermisch zersetzt und trägt zur Ausbildung einer ionisierten Atmosphäre bei.

Damit mit dem Detektionsleiter 13 Lichtbögen nachgewiesen werden können, ist es erforderlich, dass der Detektionsleiter 13 so nahe an der Plusleitung 11 und der Minusleitung 12 geführt ist, dass er bei einem auftretenden Lichtbogen durch einen durch den Lichtbogen erzeugten ionisierten Bereich geführt ist. Dies kann beispielsweise durch die oben genannten Ausführungsvarianten des Kabels 10 erreicht werden.

Fig. 2 zeigt in einer schematischen Darstellung eine Elektronikanordnung 20 zur Lichtbogenerkennung an einem Kabel 10 und einem Verbraucher 17 eines Gleichstromkreises.

Die Elektronikanordnung 20 umfasst eine Signalquelle 22, einen Vorwiderstand 24 und einen Vergleicher 23. Die Signalquelle 22 ist mit dem Vorwiderstand 24 und über eine Signalleitung 25 mit dem Vergleicher 23 verbunden. Der Vorwiderstand 24 ist an einer Einkoppelstelle 21.1 an einem losen Ende der Zuführung 13.1 des bereits zu Fig. 1 eingeführten Detektionsleiters 13 angeschlossen. Die Rückführung 13.2 des Detektionsleiters 13 ist über eine Auskoppelstelle 21.2 an den Vergleicher 23 angeschlossen. Die Zuführung 13.1 und die Rückführung 13.2 des Detektionsleiters 13 sind zusammen mit der Plusleitung 11 und der Minusleitung 12 in dem ebenfalls bereits in Fig. 1 gezeigten Kabels 10 geführt. Dabei ist die Plusleitung 11 eingangsseitig an eine Versorgungsspannung 16 und die Minusleitung 12 an ein Minuspotential 18 einer nicht dargestellten Spannungsversorgung angeschlossen. Zwischen der Plusleitung 11 und der Minusleitung 12 ist der elektrische Verbraucher 17 angeschlossen, welcher über das Kabel 10 mit elektrischer Energie versorgt wird. In unmittelbarer Nähe zu dem elektrischen Verbraucher 17 ist eine Schleife 13.3 des Detektionsleiters 13 geführt, welche die Zuführung 13.1 und die Rückführung 13.2 des Detektionsleiters 13 verbindet, so dass der Detektionsleiter 13 eine geschlossene Leiterschleife ausbildet. Entlang des Kabels 10 sind eine erste Kontaktstelle 15.1 und eine zweite Kontaktstelle 15.2 in Form von Steckkontakten ausgeführt. Die Kontaktstellen 15.1, 15.2 bilden sowohl Kontakte für die Plusleitung 11 und die Minusleitung 12 wie auch für die Zuführung 13.1 und die Rückführung 13.2 des Detektionsleiters 13 aus.

Die Signalquelle 22 und der Vergleicher 23 referenzieren auf ein gemeinsames Bezugspotential 26 mit dem Gleichstromkreis, im vorliegenden Fall auf das Minuspotential 18 des Gleichstromkreises. Alternativ kann als Bezugspotential 26 auch die Versorgungsspannung 16 oder eine beliebige Bezugsspannung des Gleichstromkreises vorgesehen sein.

Die Signalquelle 22 speist über den Vorwiderstand 24 an der Einkoppelstelle 21.1 ein Spannungssignal in die Zuführung 13.1 des Detektionsleiters 13 ein. Das Spannungssignal wird über die Kontaktstellen 15.1, 15.2 zu der Schleife 13.3 und von dort über die Rückführung 13.2 und die Kontaktstellen 15.1, 15.2 zurück zu der Auskoppelstelle 21.2 geleitet. Der Vergleicher 23 misst hochohmig die anliegenden Spannungssignale an einem Messpunkt MP1 27.1 vor dem Vorwiderstand 24 und am Ende des Detektionsleiters 13 an einem Messpunkt MP 2 27.2 und vergleicht diese. Liegt kein Lichtbogen vor, wird die Leiterschleife des Detektionsleiters 13 lediglich durch den Messstrom des Vergleichers 23 belastet. Entsprechend ist der Spannungsabfall über dem Vorwiderstand 24 vernachlässigbar, so dass vor dem Vorwiderstand 24 und an der Auskoppelstelle 21.2 im Rahmen geringer Toleranzen das gleiche Spannungssignal vorliegt. Der Vergleicher 24 erkennt, dass die Spannungssignale gleich sind und eine nicht dargestellte Verarbeitungseinrichtung, beispielsweise in Form eines Mikroprozessors, entscheidet daraufhin, dass kein Lichtbogen im Bereich des Kabels 10, der Kontaktstellen 15.1, 15.2 oder des Verbrauchers 17 vorliegt. Tritt hingegen ein Lichtbogen auf, wird die Atmosphäre im Bereich des Lichtbogens ionisiert und damit leitfähig. Der Detektionsleiter 13 ist so angeordnet, dass er durch diesen ionisierten Bereich geführt ist. Auf Grund des gemeinsamen Bezugspotentials 26 der Signalquelle 22 und des Gleichstromkreises fließt ein Strom von dem Detektionsleiter 13 in den Gleichstromkreis. Damit steigt der Spannungsabfall über dem Vorwiderstand 24, so dass das Spannungssignal an der Auskoppelstelle 21.2 gegenüber dem Spannungssignal vor dem Vorwiderstand 24 sinkt. Dies wird von dem Vergleicher 23 festgestellt. Ist die Differenz der Spannungssignale größer als ein vorgegebener zulässiger Betrag, erkennt die Verarbeitungseinrichtung auf einen Lichtbogen.

Als Spannungssignal ist bevorzugt eine Wechselspannung vorgesehen, da diese sich eindeutig von vorliegenden Gleichspannungen, wie sie bei vorliegendem Lichtbogen beispielsweise aus dem Gleichstromkreis auf die Detektionsleitung übertragen werden können, unterscheiden lässt. Der Vorwiderstand 24 ist so gewählt, dass sich bei der erwarteten Strombelastung des Detektionsleiters 13 in einem Lichtbogen ein hoher Spannungsabfall an dem Vorwiderstand 24 und damit eine große Spannungsdifferenz zwischen dem Spannungssignal vor dem Vorwiderstand 24 und dem Spannungssignal an der Auskoppelstelle 21.1 ergibt. Vorteilhaft ist ein Vorwiderstand 24 im Bereich zwischen 300 Ohm und 3000 Ohm vorgesehen. Ein solcher Vorwiderstand 24 führt bereits bei entstehendem Lichtbogen mit einer vergleichsweise geringen Ionisierung der Atmosphäre zu einem deutlichen Spannungsabfall und somit zu einer eindeutig nachweisbaren Änderung des Spannungssignals an der Auskoppelstelle 21.1 und damit dem Messpunkt MP2 27.2. Bei entsprechender Wahl des Vorwiderstandes 24 bricht das Spannungssignal an dem Detektionsleiter 13 vollständig ein, was durch den Vergleicher 23 eindeutig nachweisbar ist.

Der Detektionsleiter 13 ist in dem Ausführungsbeispiel zusammen mit der Plusleitung 11 und der Minusleitung 13 in dem Kabel 10 geführt. Dabei ist der Detektionsleiter 13 in den Kontaktstellen 15.1, 15.2 ebenfalls durch Kontakte verbunden. Die Schleife 13.3 ist unmittelbar an oder in dem Verbraucher 17 geführt. Dabei kann der Detektionsleiter 13 im Bereich des Verbrauchers 17 flächig als Sensorblech ausgeführt sein. Auf diese Weise können Lichtbögen entlang des Kabels 10, in den Kontaktstellen 15.1, 15.1 sowie in dem Verbraucher 17 erkannt werden.

Wird ein Lichtbogen erkannt, wird die Spannungsversorgung des Gleichstromkreises unterbrochen. Dazu ist nicht dargestellt in dem Gleichstromkreis eine Hochleistungs-Trenneinrichtung vorgesehen, welche beispielsweise eine Batterie und/oder einen Generator von dem Gleichstromkreis trennt. Als Hochleistungs-Trenneinrichtungen können Relais, elektronische Trenneinrichtungen oder pyrotechnische Sicherungen verwendet werden. Dabei kann die Hochleistungs-Trenneinrichtung unmittelbar an oder in der Batterie oder an dem Generator vorgesehen sein.

Bei der gezeigten Anordnung handelt es sich um ein passives Sicherheitssystem. Passive Sicherheitssysteme zeichnen sich dadurch aus, dass der stromlose Zustand den sicheren Zustand darstellt. Tritt ein Fehler auf, durch den die erwarteten Ströme nicht fließen, schaltet ein solches passives Sicherheitssystem auf Störung. Im vorliegenden Fall erkennt das Sicherheitssystem auf einen Lichtbogen und schaltet die Versorgungsspannung 16 des Gleichstromkreises ab, falls in dem Detektionsleiter 13 ein Fehler auftritt, durch welchen das Spannungssignal an der Auskoppelstelle 21.2 verändert wird. Das System fällt somit auf jeden Fall in den sicheren Zustand. Es liegt ein geschlossener Stromkreis des Detektionsleiters 13 vor, der im Betrieb ständig auf eine Unterbrechung überprüft wird und im Falle einer Unterbrechung bei voller Sicherheit abschaltet. Dies bietet deutliche Vorteile gegenüber einem aktiven Sicherheitssystem, welches im Grundzustand stromlos ist und im Fehlerfall zu einem Stromfluss führt. Bei solchen aktiven Systemen ist es erforderlich, die Stromverbindungen und die Übergangswiderstände der Kontakte des Sensorsystems permanent und entsprechend aufwändig zu überwachen. Durch das vorliegende passive Sicherheitssystem können sehr geringe Fehlerraten im Bereich von 10⁻¹⁰ Fehlern pro Jahr erreicht werden. Dies ermöglicht eine Zertifizierung entsprechend der gültigen Vorgaben für automobile Sicherheitsschaltungen.

Entsprechend einer nicht dargestellten Ausführungsvariante kann der Detektionsleiter 13 bei fliegenden Verbindungen, beispielsweise bei elektrischen Anschlüssen an Sattelschleppern, als Interlockschaltung ausgeführt sein. Bei solchen Interlockschaltungen muss zunächst eine Sensorleitung, im vorliegenden Fall der Detektionsleiter 13, unterbrochen werden, bevor ein Hauptstecker des Gleichstromkreises gezogen werden kann. Dadurch wird der Gleichstromkreis vor dem Trennen des Hauptsteckers sicher stromlos geschaltet.

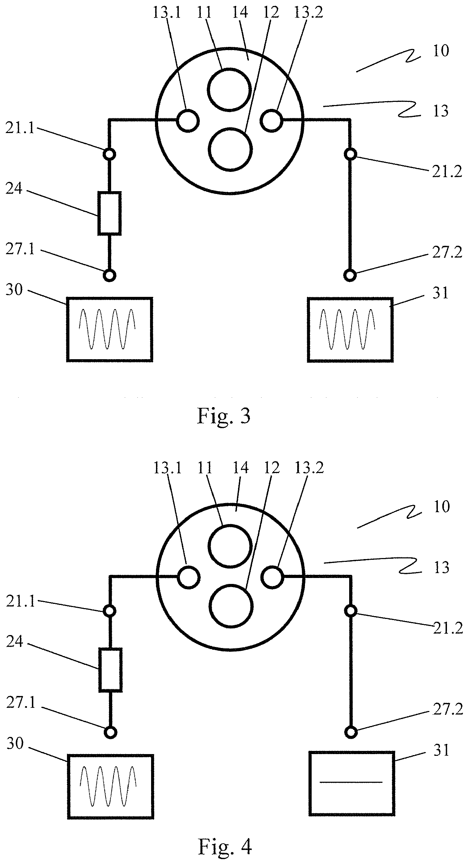

Fig. 3 zeigt das bereits in Fig. 1 gezeigte Kabel 10 mit zu vergleichenden Signalverläufen 30, 31 im regulären Betrieb des Gleichstromkreises ohne Lichtbogen. Dabei entspricht der Signalverlauf MP1 30 dem Ausgangssignal der in Fig. 2 gezeigten Signalquelle 22 am Messpunkt MP1 27.1 vor dem Vorwiderstand 24. Der Signalverlauf MP2 31 liegt an dem Messpunkt MP2 27.2 an und entspricht dem Spannungssignal, welches sich an der Auskoppelstelle 21.2 am Ende der Rückführung 13.2 des Detektionsleiters 13 einstellt.

Als Ausgangssignal der Signalquelle 22 ist eine Wechselspannung mit einer Frequenz in einem Bereich zwischen beispielsweise 20 und 50Hz vorgesehen. Um den Störspannungsabstand zu Störungen, wie sie durch die Plusleitung 11 eingebracht werden können, möglichst groß zu halten ist die Amplitude der Wechselspannung möglichst groß gewählt. Im vorliegenden Ausführungsbeispiel liegt die Amplitude der Wechselspannung über der Spannung des Gleichstromkreises von 48V.

Das Spannungssignal der Signalquelle 22 mit dem Signalverlauf MP1 30 wird, ausgehend von dem Messpunkt MP1 27.1 über den Vorwiderstand 24 und die Einkoppelstelle 21.1 in die Zuführung 13.1 des Detektionsleiters 13 eingekoppelt, durch diesen entsprechend Fig. 2 entlang des Kabels 10 und der Schleife 13.3 zu der Rückführung 13.2 geleitet, an der Auskoppelstelle 21.2 aus dem Detektionsleiter 13 ausgekoppelt und an den Messpunkt MP2 27.2 weitergeleitet. Der Vergleicher 23 vergleicht den Signalverlauf MP1 30 am Messpunkt MP1 27.1 mit dem Signalverlauf MP2 31 am Messpunkt MP2 27.2. Im vorliegenden Fall liegt entlang des Verlaufs des Detektionsleiters 13 kein Lichtbogen vor, so dass der Detektionsleiter 13 nicht elektrisch belastet wird. Der Signalverlauf MP2 31 am Ende des Detektionsleiters 13 entspricht in seiner Amplitude, aber auch in seiner Phase und Frequenz, demnach dem Signalverlauf MP1 30 am Messpunkt MP1 27.1 vor dem Vorwiderstand 24. Daraufhin entscheidet eine nicht gezeigte Verarbeitungseinrichtung, dass kein Lichtbogen vorliegt.

Fig. 4 zeigt das in Fig. 1 gezeigte Kabel 10 mit den zu vergleichenden Signalverläufen 30, 31 aus Fig. 3 bei Auftreten eines Lichtbogens. Tritt ein Lichtbogen, beispielsweise innerhalb des Kabels 10 oder an dem in Fig. 2 gezeigten Verbraucher 17, auf, so fließt ein Strom von dem Detektionsleiter 13 zu dem Gleichstromkreis. Der Detektionsleiter 13 wird demnach elektrisch belastet, so dass das von der Signalquelle 22 ausgegebene Spannungssignal über dem Vorwiderstand 24 abfällt. Im vorliegenden Ausführungsbeispiel ist der Detektionsleiter 13 durch den Kurzschluss über die ionisierte Atmosphäre des Lichtbogens so stark belastet, dass das Spannungssignal am Ende des Detektionsleiters 13 entsprechend dem Signalverlauf MP2 31 vollständig zusammenbricht. Der in Fig. 2 gezeigte Vergleicher 23 misst die Differenz zwischen dem Signalverlauf MP1 30 vor dem Vorwiderstand 24 und dem Signalverlauf MP2 31 am Ende des Detektionsleiters 13 und die nicht dargestellte Verarbeitungseinrichtung erkennt auf Grund der nachgewiesenen Differenz auf einen Lichtbogen innerhalb des Gleichstromkreises.

Fig. 5 zeigt die in Fig. 2 gezeigte Elektronikanordnung 20 zur Lichtbogenerkennung mit einer integrierten Sicherheitsschaltung 40 zur Überwachung und Wartung des Detektionsleiters 13. Bereits zu Fig. 2 gezeigte Bauelemente sind dabei gleich bezeichnet. Zur vereinfachten Darstellung sind im Gegensatz zu Fig. 2 die Komponenten des Gleichstromkreises nicht gezeigt. Der Gleichstromkreis ist z. B. Teil eines 48V-Bordnetzes eines Kraftfahrzeugs.

Die Elektronikanordnung 20 enthält zusätzlich eine Wartungs- und Diagnoseeinheit 40. Diese umfasst, ausgehend von einer Spannungsversorgung 41, ein erstes Relais 42, einen Widerstand 43 und ein zweites Relais 45.

Die Spannungsversorgung 41 kann über das erste Relais 42 mit dem Widerstand 43 verbunden werden, welcher gegenüberliegend über die Einkoppelstelle 21.1 an der Zuführung 13.1 des Detektionsleiters 13 angeschlossen ist. Das Ende des Detektionsleiters 13 ist über die Auskoppelstelle 21.2 mit dem zweiten Relais 45 verbunden, welches geschaltet eine Verbindung zu Masse 19 herstellt. Am Anfang und am Ende des Detektionsleiters 13 ist jeweils eine Messstelle 44.1, 44.2 vorgesehen.

Die Wartungs- und Diagnoseeinheit 40 dient der Wartung von Kontakten der Vorrichtung zur Lichtbogenerkennung, insbesondere der Vermeidung hoher Übergangswiderstände durch Korrosion. Solche hohen Übergangswiderstände können beispielsweise an den Kontakten des Detektionsleiters 13 an den Kontaktstellen 15.1, 15.2 auftreten. Nach einer Abschaltung des Gleichstromkreises, beispielsweise nach dem Ausschalten eines Motors des Kraftfahrzeugs, werden die Relais 42, 45 für eine vorgegebene Zeitdauer, beispielsweise für 30s, geschlossen. In dieser Zeit fließt ein Regenerationsstrom von der Spannungsversorgung 16 über das erste Relais 42, die Zuführung 13.1, die Schleife 13.3 und die Rückführung 13.2 des Detektionsleiters 13 mit den darin vorgesehenen Kontaktstellen 15.1, 15.2 über das zweite Relais 45 zur Masse 19. Der Regenerationsstrom ist dabei durch geeignete Wahl der Spannungsversorgung 41 und des Widerstandes 43 auf beispielsweise 1 Ampere festgelegt. Ein solcher zeitweise angelegte Regenerationsstrom verhindert sicher eine schleichende Korrosion der Kontakte. Dabei können die Übergangswiderstände an den Messstellen 44.1, 44.2 über die gesamte Länge des Detektionsleiters 13, beispielsweise auf besser 500 mΩ, geprüft werden. Liegen dennoch höhere Übergangswiderstände vor, erfolgt eine entsprechende Fehlermeldung und die Werkstatt oder ein Fahrer erhalten frühzeitig einen Wartungshinweis. Die Sicherheit ist bei dem vorliegenden passiven Sicherheitssystem jedoch weiterhin gewährleistet, da ein Lichtbogen auch bei erhöhten Übergangswiderständen weiterhin erkannt wird. Hohe Übergangswiderstände können lediglich zu einer fehlerhaften Lichtbogenerkennung führen, was durch die Wartungs- und Diagnoseeinheit 40 vermieden werden kann.

Fig. 6 zeigt in einer Ausführungsvariante der Erfindung ein Kabelpaar mit einem einpoligen Pluskabel 50 und einem einpoligen Minuskabel 51. In der Ummantelung 14 des Pluskabels 50 sind die Plusleitung 11 und die Zuführung 13.1 des Detektionsleiters 13 geführt. In der Ummantelung 14 des Minuskabels 50 sind die Minusleitung 12 und die Rückführung 13.2 des Detektionsleiters 13 geführt. Die Zuführung 13.1 und die Rückführung 13.2 sind am Ende des Pluskabels 50 und des Minuskabels 51 mit einer in den Figuren 2 und 5 gezeigten Schleife 13.3 zu einer geschlossenen Leiterschleife verbunden.

Bei heute geplanten Kraftfahrzeugen mit 42V oder 48V Bordnetzen werden vielfach sowohl die positive wie die negative Spannung über isolierte Leitungen (z. B. Plusleitungen 11) und Minusleitungen 12 zu den Verbrauchern geleitet und es wird auf die Verwendung einer gemeinsamen Fahrzeugmasse verzichtet. Hintergrund ist die Gefahr einer möglichen Beschädigung des Pluskabels 50, beispielsweise an scharfkantigen Karosserieteilen, was unmittelbar zu einem Kurzschluss mit dem Risiko einer Lichtbogenbildung führen kann. Diese Gefahr wird durch die getrennte Zuführung der positiven und negativen Spannung über separate Plusleitungen 11 und Minusleitungen 12 deutlich verringert. Die Gefahr eines Kurzschlusses kann dabei durch die Verwendung getrennter einpoliger Pluskabel 50 und einpoliger Minuskabel 51 gegenüber in den Fig. 1, 3 und 5 gezeigten zweipoligen Kabeln 10, in denen sowohl die Plusleitung 11 wie die Minusleitung 12 gemeinsam geführt sind, weiter verringert werden. Mit dem dargestellten Kabelpaar können auch solche einpoligen Pluskabel 50 und Minuskabel 51 auf Lichtbögen überwacht werden, wodurch die Betriebssicherheit weiter erhöht wird.

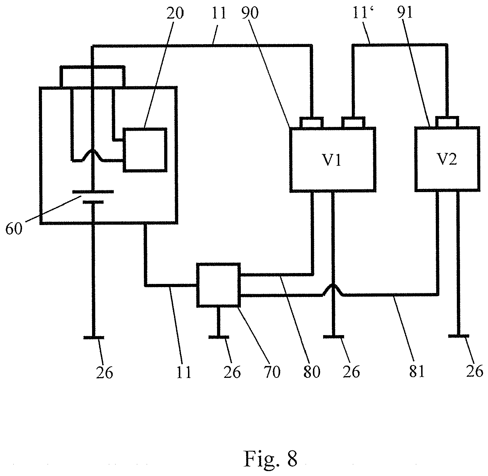

Ist das Kraftfahrzeug mit einer erfindungsgemäßen Lichtbogenerkennung mit Abschaltung des Gleichstromkreises bei Erkennung eines Lichtbogens ausgerüstet, kann auch bei einem 42V-Bordnetz oder einem 48V-Bordnetz wirtschaftlich vorteilhaft die Karosserie (in der Regel) als Minuspol verwendet werden. Damit muss nur ein Pluskabel 50 zu dem Verbraucher 17 geführt und mit einem Detektionsleiter 13 überwacht werden, während der negative Anschluss des Verbrauchers 17 auf der Fahrzeugmasse liegt, wie Fig. 8 zeigt. Tritt, wie oben beschrieben, ein Lichtbogen zwischen der Plusleitung 11 und der Fahrzeugmasse auf, wird dies über den Detektionsleiter sofort entdeckt werden, und die Spannungsversorgung des Gleichstromkreises wird unmittelbar unterbrochen, womit die Sicherheit gewährleistet ist. Durch Einsparung der Minusleitung 12 können die Kosten für die elektrische Verkabelung des Kraftfahrzeugs deutlich reduziert werden. Weiterhin kann das Gewicht des Kraftfahrzeugs verringert werden. In einer Modifikation des in Fig. 6 gezeigten Pluskabels 50 ist der Detektionsleiter 13 dabei vorzugsweise mit seiner endseitig über eine Schleife 13.3 verbundenen Zuführung 13.1 und Rückführung 13.2 entlang oder in dem Pluskabel 50 geführt, wie Fig. 7 zeigt. Damit liegt eine geschlossene Leiterschleife bzw. Ringleitung vor.

Bei dem in Fig. 8 gezeigten Ausführungsbeispiel mit der Elektronikanordnung 20 bildet die Fahrzeugmasse bzw. die Karosserie den Minuspol. Dabei versorgt eine Batterie 60 beispielhaft zwei Verbraucher 90, 91. Der Rückstrom fließt über die Fahrzeugmasse. Bei Rückströmen über die Fahrzeugmasse ist aber undefiniert, wie der Strom lokal fließen wird. Wenn zum Beispiel der Verbraucher zur Herstellung des Minus-Kontaktes mit zwei Schrauben an die Fahrzeugmasse geschraubt ist und diese Schrauben nicht angezogen sind, ist nicht vorhersehbar, an welcher dieser beiden Schrauben der Lichtbogen entstehen wird. Grundsätzlich trifft man bei einem flächigen Leiter, wie dem Fahrzeugrahmen bzw. der Karosserie, mit einer Detektionsleitung die Position eines potentiellen Lichtbogens nicht mehr. Es besteht aber grundsätzlich das Problem des seriellen Lichtbogens längs der Masseanbindung. Hier ist eine Anordnung wie in Fig. 8 zweckmäßig. Eine Messeinrichtung 70 vergleicht für jeden Verbraucher 90, 91mit den Stichleitungen 80 und 81, die möglichst in den Verbraucher 90, 91 hineingehen, dass alle Verbraucher, relativ zur Batterie 60, die gleiche Masse haben. Da die Lichtbogen-Schwelle bei grob 18 Volt liegt, genügt es, die Ansprechschwelle auf Massedifferenzen größer 5 bis 10 Volt zu legen. Das ist sehr einfach darstellbar und hochwirksam. Die Elektronikanordnung 20 ist vorzugsweise eng mit der Batterie verbunden.

Bei dem Ausführungsbeispiel nach Fig. 8 können die Plusleitungen 11 und 11' wie in Fig. 7 gezeigt ausgeführt sein. Damit erreicht man eine definiert geführte Ringleitung und Verteilerboxen werden für die Versorgungsspannung vermieden. Bei dieser Anordnung besitzt die Plusleitung einen Schutz gegen alle Arten von Lichtbögen, nämlich Unterbrechungs- und Kurzschlusslichtbögen. Die Masseleitung über den Fahrzeugrahmen ist allein gegen Unterbrechungslichtbögen geschützt, was aber genügt.

Bei der Abschaltung der Versorgungsspannung (von zum Beispiel 48 V) durch Trenneinrichtungen wie Relais und/oder pyrotechnische Sicherungen ist zu beachten, dass neben der Batterie auch der Generator bzw. die Lichtmaschine abgeworfen werden sollte. Einen hohen Sicherheitsstandard erreicht man mit der Elektronikanordnung 20 in Verbindung mit der Auswerte- und Abschaltelektronik vorteilhaft dadurch, dass zwei sich gegenseitig überwachende Mikroprozessoren vorhanden sind.

Viele Hochstrom-Verbindungen bei einer 48 Volt-Versorgungsspannung werden geschraubt. Hier ist es vorteilhaft, die Kontaktierung der eng benachbarten Detektionsleitung so auszuführen, dass erst der Detektionsleiter getrennt wird, bevor die Schraube betätigt werden kann. Auf diese Weise erreicht man, dass eine solche Schraube nicht unter Last geöffnet werden kann. Bei Steck-Kontaktierungen sind in gleicher Weise beim Stecken nacheilende Detektionskontakte vorteilhaft, so dass Kontaktierungen unter Last weder geöffnet noch geschlossen werden können.

Luxusbusse haben mit 24 Volt beaufschlagte Kabellängen von oft mehr als ingesamt 10 km Länge. Von diesen 24 Volt-Kabeln geht eine sehr reale Gefahr aus. Ein häufiger Unfall bei Bussen ist, dass als Folge eines Motorraumbrandes die Isolierungen von Versorgungskabeln im Motorraum schmelzen, diese Leitungen mit dem Fahrzeugrahmen in Kontakt kommen, und der Bus danach in einem Lichtbogen-Flammenmeer untergeht. Hierzu muss man wissen, dass die technische Spannung eines Busses mit laufendem Motor bei 28 Volt liegt.

Eine Lösung bei den Bussen ist hierfür, nur 1 bis 2 % der relevanten Versorgungsleitungen, wie bei den derzeitigen PKW Konzepten angedacht, bei Bussen in 24 oder 36 oder 48 Volt Nennspannung auszuführen und so einen Schutz mit den vorstehend erläuterten Maßnahmen vorzusehen. Bei solchen Bussen kann der Rest des Busses mit 12 Volt und 2 oder 3 verteilten 12 Volt Stützbatterien betrieben werden. Eine Startkonfiguartion mit 24 Volt für die relevanten Versorgungsleitungen und 12 Volt für den Rest des Busses ist vorteilhaft, da es diese Komponenten alle schon gibt.

## Patentansprüche

1. Verfahren zur Lichtbogenerkennung in einem Gleichstromkreis mit einem Detektionsleiter (13), welcher zumindest entlang einem eine elektrische Spannung führenden und zu überwachenden Leiter des Gleichstromkreises geführt ist,
**dadurch gekennzeichnet,**
**dass** ein auf ein Potential des Gleichstromkreises bezogenes Spannungssignal, das durch einen Generator (22) erzeugt wird, über einen Vorwiderstand (24) an einer Einkoppelstelle (21.1) in den Detektionsleiter (13) eingekoppelt wird, dass das Spannungssignal an einer Auskoppelstelle (21.2) des Detektionsleiters (13) wieder ausgekoppelt wird, dass das Spannungssignal vor dem Vorwiderstand (24) mit dem Spannungssignal an der Auskoppelstelle (21.2) verglichen wird und dass auf einen Lichtbogen geschlossen wird, wenn das Spannungssignal an der Auskoppelstelle (21.2) um mehr als einen vorgegebenen Betrag von dem Spannungssignal vor dem Vorwiderstand (24) abweicht.

2. Verfahren nach Anspruch 1,
**dadurch gekennzeichnet,**
**dass** als Spannungssignal ein Gleichspannungssignal oder ein Wechselspannungssignal oder ein von einer Wechselspannung überlagertes Gleichspannungssignal verwendet wird.

3. Verfahren nach Anspruch 1 oder 2,
**dadurch gekennzeichnet,**
**dass** die Spannungsversorgung des Gleichstromkreises unterbrochen wird, wenn ein Lichtbogen erkannt wird.

4. Vorrichtung zur Lichtbogenerkennung in einem Gleichstromkreis, mit einem Detektionsleiter (13), welcher zumindest entlang einem eine elektrische Spannung führenden und zu überwachenden Leiter des Gleichstromkreises geführt ist,
**dadurch gekennzeichnet,**
**dass** der Detektionsleiter (13) an einer Einkoppelstelle (21.1) über einen Vorwiderstand (24) mit einer ein Spannungssignal ausgebenden Signalquelle (22) verbunden ist, dass das Spannungssignal der Signalquelle (22) auf ein Potential des zu überwachenden Gleichspannungsstromkreises bezogen ist, dass das von der Signalquelle (22) ausgegebene Spannungssignal und ein an einer Auskoppelstelle (21.2) des Detektionsleiters (13) ausgegebenes Spannungssignal einem Vergleicher (23) zugeführt ist und dass der Vorrichtung eine Verarbeitungseinrichtung zugeordnet ist, welche auf einen Lichtbogen erkennt, wenn das an der Auskoppelstelle (21.2) vorliegende Spannungssignal über einen vorgegebenen Betrag von dem von der Signalquelle (22) ausgegebenen Spannungssignal abweicht.

5. Vorrichtung nach Anspruch 4,
**dadurch gekennzeichnet,**
**dass** der Detektionsleiter (13) als geschlossene Leiterschleife ausgeführt ist, wobei die Einkoppelstelle (21.1) und die Auskoppelstelle (21.2) an den Enden der Leiterschleife angeordnet sind.

6. Vorrichtung nach Anspruch 4 oder 5,
**dadurch gekennzeichnet,**
**dass** der Detektionsleiter (13) an Kontaktstellen (15.1, 15.2) des zu überwachenden Gleichstromkreises ebenfalls als Kontakt ausgeführt ist und/oder dass der Kontakt des Detektionsleiters (13) als Interlockschaltung mit einer Verzögerungseinrichtung für die Öffnung der Kontaktstelle ausgeführt ist.

7. Vorrichtung nach einem der Ansprüche 4 bis 6,
**dadurch gekennzeichnet,**
**dass** der Detektionsleiter (13) durch Verbraucher (17) hindurch oder entlang von Verbrauchern (17) des Gleichstromkreises geführt ist und/oder dass der Detektionsleiter (13) durch Kabel (10, 50, 51) oder entlang von Kabeln (10, 50, 51) des Gleichstromkreises geführt ist.

8. Vorrichtung nach einem der Ansprüche 4 bis 7,
**dadurch gekennzeichnet,**
**dass** der Vorwiderstand (24) in einem Bereich zwischen 10 Ohm und 10.000 Ohm oder zwischen 100 Ohm und 10.000 Ohm oder bevorzugt in einem Bereich zwischen 300 Ohm und 3000 Ohm, liegt.

9. Vorrichtung nach einem der Ansprüche 4 bis 8,
**dadurch gekennzeichnet,**
**dass** die Signalquelle (22) als Wechselspannungsquelle oder als Gleichspannungsquelle oder als Wechselspannungsquelle mit überlagertem Gleichspannungsoffset ausgeführt ist.

10. Vorrichtung nach einem der Ansprüche 4 bis 9,
**dadurch gekennzeichnet,**
**dass** die Verarbeitungseinrichtung dazu ausgelegt ist, bei einem erkannten Lichtbogen eine Trenneinrichtung anzusteuern, welche die Spannungsversorgung des Gleichstromkreises unterbricht.

11. Vorrichtung nach einem der Ansprüche 4 bis 10,
**dadurch gekennzeichnet,**
**dass** der Detektionsleiter (13) zumindest bereichsweise isoliert ausgeführt ist und/oder dass der Detektionsleiter (13) zumindest bereichsweise ohne Isolation ausgeführt ist.

12. Vorrichtung nach einem der Ansprüche 4 bis 11 ,
**dadurch gekennzeichnet,**
**dass** Verbraucher (17) des Gleichstromkreises einseitig auf einer Fahrzeugmasse liegen und dass die Versorgungsspannung (16) über mit Detektionsleitern (13) überwachte Plusleitungen (11) zu den Verbrauchern (17) geleitet ist.

13. Vorrichtung nach einem der Ansprüche 4 bis 12,
**dadurch gekennzeichnet,**
**dass** sie eine eine Wartungs- und Diagnoseeinheit (40) enthaltende Elektronikeinheit (20) aufweist, die als Sicherheitsschaltung zur Überwachung und Wartung des Detektionsleiters (13) ausgebildet ist.

14. Vorrichtung nach Anspruch 13,
**dadurch gekennzeichnet,**
**dass** die Wartungs- und Diagnoseeinheit (40) ausgehend von einer Spannungsversorgung (41) ein erstes Relais (42), einen Widerstand (43) und ein zweites Relais (45) umfasst.

15. Anwendung des Verfahrens und der Vorrichtung nach einem der Ansprüche 1 bis 12 zur Überwachung eines Gleichstromkreises in einem Spannungsbereich zwischen 24V und 60V oder zur Überwachung eines Gleichstromkreises in einem Kraftfahrzeug in einem Spannungsbereich zwischen 24V und 60V, vorzugsweise in einem Spannungsbereich zwischen 40V und 50V.

## Claims

1. A method for detecting arcs in a DC circuit, having a detection conductor (13), which is routed at least along a conductor of the DC circuit, which carries an electric voltage and is to be monitored,
**characterized in that**
a voltage signal, which refers to a potential of the DC circuit and is produced by means of a generator (22), is coupled into the detection conductor (13) at an incoupling point (21.1) via a series resistor (24), the voltage signal is coupled out again at an outcoupling point (21.2) of the detection conductor (13), the voltage signal before the series resistor (24) is compared to the voltage signal at the outcoupling point (21.2), and the conclusion is drawn that an arc has occurred when the voltage signal at the outcoupling point (21.2) deviates from the voltage signal before the series resistor (24) by more than a predetermined amount.

2. The method according to claim 1,
**characterized in that**
a DC voltage signal, an AC voltage signal, or a DC voltage signal that is overlaid with an AC voltage is used as the voltage signal.

3. The method according to claim 1 or 2,
**characterized in that**
the power supply of the DC circuit is interrupted when an arc is detected.

4. A device for detecting arcs in a DC circuit, having a detection conductor (13), which is routed at least along a conductor of the DC circuit, which carries an electric voltage and is to be monitored,
**characterized in that**
the detection conductor (13) is connected at an incoupling point (21.1) via a series resistor (24) to a signal source (22) that outputs a voltage signal, the voltage signal of the signal source (22) refers to a potential of the DC circuit to be monitored, the voltage signal output by the voltage source (22) and a voltage signal output at an outcoupling point (21.2) of the detection conductor (13) are supplied to a comparator (23), and the device is associated with a processing device that detects an arc if the voltage signal, which is present at the outcoupling point (21.2), deviates from the voltage signal output by the signal source (22) by more than a predetermined amount.

5. The device according to claim 4,
**characterized in that**
the detection conductor (13) is embodied as a closed conductor loop, with the incoupling point (21.1) and the outcoupling point (21.2) being located at the ends of the conductor loop.

6. The device according to claim 4 or 5,
**characterized in that**
at contact points (15.1, 15.2) of the DC circuit to be monitored, the detection conductor (13) is likewise embodied as a contact and/or the contact of the detection conductor (13) is embodied as an interlock circuit with a delay device for the opening of the contact point.

7. The device according to one of claims 4 through 6,
**characterized in that**
the detection conductor (13) is routed through consumers (17) or alongside consumers (17) of the DC circuit and/or the detection conductor (13) is routed through cable cables (10, 50, 51) or alongside cables (10, 50, 51) of the DC circuit.

8. The device according to one of claims 4 through 7,
**characterized in that**
the series resistor (24) lies in a range between 10 ohm und 10,000 ohm, between 100 ohm and 10,000 ohm, or preferably in a range between 300 ohm and 3000 ohm.

9. The device according to one of claims 4 through 8,
**characterized in that**
the signal source (22) is embodied as an AC voltage source, a DC voltage source, or an AC voltage source with an overlaid DC voltage offset.

10. The device according to one of claims 4 through 9,
**characterized in that**
the processing device is designed to react to the detection of an arc by tripping a circuit breaker, which interrupts the power supply of the DC circuit.

11. The device according to one of claims 4 through 10,
**characterized in that**
the detection conductor (13) is embodied as insulated in at least some areas and/or the detection conductor (13) is embodied without insulation in at least some areas.

12. The device according to one of claims 4 through 11,
**characterized in that**
consumers (17) of the DC circuit are connected to a vehicle ground on one side and the supply voltage (16) is conveyed to the consumers (17) via plus lines (11) that are monitored by means of detection conductors (13).

13. The device according to one of claims 4 through 12,
**characterized in that**
it has an electronic unit (20) which contains a maintenance and diagnosis unit (40) and which is designed as a safety circuit for monitoring and maintaining the detection conductor (13).

14. The device according to claim 13,
**characterized in that**
the maintenance and diagnosis unit (40), starting from a voltage supply (41), comprises a first relay (42), a resistor (43) and a second relay (45).

15. A use of the method and device according to one of claims 1 through 12 for monitoring a DC circuit in a voltage range between 24 V and 60 V or for monitoring a DC circuit in a motor vehicle in a voltage range between 24 V and 60 V, preferably in a voltage range between 40 V and 50 V.

## Revendications

1. Procédé de détection d'arcs électriques dans un circuit de courant continu, comportant un conducteur de détection (13), lequel est guidé le long d'au moins un conducteur du circuit de courant continu conduisant une tension électrique et devant être surveillé,
**caractérisé en ce**
**qu'**un signal de tension qui se rapporte à un potentiel du circuit de courant continu et qui est produit par un générateur (22) est couplé à un point de couplage (21.1) dans le conducteur de détection (13) par l'intermédiaire d'une résistance série (24), **en ce que** le signal de tension est à nouveau découplé au niveau d'un point de découplage (21.2) du conducteur de détection (13), **en ce que** le signal de tension est comparé, avant la résistance série (24), au signal de tension au point de découplage (21.2), et **en ce qu'**un arc électrique est fermé lorsque le signal de tension au point de découplage (21.2) s'écarte du signal de tension de plus d'une valeur prédéterminée avant la résistance série (24).

2. Procédé selon la revendication 1,
**caractérisé en ce**
**qu'**un signal de tension continue, un signal de tension alternative ou un signal de tension continue superposé par une tension alternative est utilisé comme signal de tension.

3. Procédé selon la revendication 1 ou 2,
**caractérisé en ce**
**que** l'alimentation électrique du circuit de courant continu est interrompue lorsqu'un arc électrique est détecté.

4. Dispositif de détection d'arcs électriques dans un circuit de courant continu, comportant un conducteur de détection (13), lequel est guidé le long d'au moins un conducteur du circuit de courant continu conduisant une tension électrique et devant être surveillé,
**caractérisé en ce**
**que** le conducteur de détection (13) est relié à une source de signal (22) émettant un signal de tension au niveau d'un point de couplage (21.1) par l'intermédiaire d'une résistance série (24), **en ce que** le signal de tension de la source de signal (22) se rapporte à un potentiel du circuit de tension continue devant être surveillé, **en ce que** le signal de tension émis par la source de signal (22) et un signal de tension émis au niveau d'un point de découplage (21.2) du conducteur de détection (13) sont acheminés vers un comparateur (23), et **en ce qu'**un dispositif de traitement est associé au dispositif, lequel dispositif de traitement détecte un arc électrique lorsque le signal de tension présent au point de découplage (21.2) s'écarte du signal de tension (22) émis par la source de tension au-delà d'une valeur prédéterminée.

5. Dispositif selon la revendication 4,
**caractérisé en ce**
**que** le conducteur de détection (13) est réalisé comme une boucle conductrice fermée, le point de couplage (21.1) et le point de découplage (21.2) étant disposés aux extrémités de la boucle conductrice.

6. Dispositif selon la revendication 4 ou 5,
**caractérisé en ce**
**que** le conducteur de détection (13) est également réalisé comme un contact aux points de contact (15.1, 15.2) du circuit de courant continu devant être surveillé et/ou **en ce que** le contact du conducteur de détection (13) est réalisé comme un circuit de verrouillage doté d'un ralentisseur pour ouvrir le point de contact.

7. Dispositif selon l'une des revendications 4 à 6,
**caractérisé en ce**
**que** le conducteur de détection (13) est guidé à travers des consommateurs (17) ou le long de consommateurs (17) du circuit de courant continu et/ou **en ce que** le conducteur de détection (13) est guidé à travers des câbles (10, 50, 51) ou le long de câbles (10, 50, 51) du circuit de courant continu.

8. Dispositif selon l'une des revendications 4 à 7,
**caractérisé en ce**
**que** la résistance série (24) est comprise entre 10 et 10 000 ohms ou entre 100 et 10 000 ohms ou de préférence entre 300 et 3 000 ohms.

9. Dispositif selon l'une des revendications 4 à 8,
**caractérisé en ce**
**que** la source de signal (22) est réalisée comme une source de tension alternative, comme une source de tension continue ou comme une source de tension alternative avec décalage de courant continu superposé.

10. Dispositif selon l'une des revendications 4 à 9,
**caractérisé en ce**
**que** le dispositif de traitement est conçu pour commander un dispositif de déconnexion qui interrompt l'alimentation électrique du circuit de courant continu lorsqu'un arc électrique est détecté.

11. Dispositif selon l'une des revendications 4 à 10,
**caractérisé en ce**
**que** le conducteur de détection (13) est isolé au moins par zones et/ou **en ce que** le conducteur de détection (13) est réalisé sans isolation au moins par zones.

12. Dispositif selon l'une des revendications 4 à 11,
**caractérisé en ce**
**que** des consommateurs (17) du circuit de courant continu se trouvent exclusivement sur une masse du véhicule, et **en ce que** la tension d'alimentation (16) est acheminée vers les consommateurs (17) par des lignes positives (11) qui sont surveillées par des conducteurs de détection (13).

13. Dispositif selon l'une des revendications 4 à 12,
**caractérisé en ce**
**qu'**il comporte une unité électronique (20) contenant une unité d'entretien et de diagnostic (40), laquelle unité électronique est conçue comme un circuit de sécurité pour la surveillance et l'entretien du conducteur de détection (13).

14. Dispositif selon la revendication 13,
**caractérisé en ce**
**que** l'unité d'entretien et de diagnostic (40), à partir d'une alimentation électrique (41), comprend un premier relais (42), une résistance (43) et un second relais (45).

15. Application du procédé et du dispositif selon l'une des revendications 1 à 12 pour la surveillance d'un circuit de courant continu dans une plage de tension comprise entre 24 V et 60 V ou pour la surveillance d'un circuit de courant continu dans un véhicule automobile dans une plage de tension comprise entre 24 V et 60 V, de préférence entre 40 V et 50 V.
